## Europäisches Patentamt

## European Patent Office

## Office européen des brevets

(11) Veröffentlichungsnummer : **0 038 981**
**B1**

(12) **EUROPÄISCHE PATENTSCHRIFT**

(45) Veröffentlichungstag der Patentschrift :
26.09.84

(51) Int. Cl.³ : **H 01 S 3/19**

(21) Anmeldenummer : **81102765.5**

(22) Anmeldetag : **10.04.81**

(54) **Laser-Diode.**

(30) Priorität : **30.04.80 DE 3016778**

(43) Veröffentlichungstag der Anmeldung :
**04.11.81 Patentblatt 81/44**

(45) Bekanntmachung des Hinweises auf die Patenterteilung : **26.09.84 Patentblatt 84/39**

(84) Benannte Vertragsstaaten :
**FR GB**

(56) Entgegenhaltungen :
**FR-A- 2 437 083**
**IBM TECHNICAL DISCLOSURE BULLETIN, Band 16, Nr. 11, April 1974, Seiten 3808-3809 New York, U.S.A. A.W. SMITH et al.: "Lattice matched double hetero-junction visible injection laser for room temperature continuous wave operation"**
**JOURNAL OF APPLIED PHYSICS, Band 45, Nr. 11, November 1974, Seiten 4735-4737 New York, U.S.A. R.L. BROWN et al.: "Stress compensation in GaAs-A10.24Ga0.76As1-y Py-LPE binary layers"**

(73) Patentinhaber : **Siemens Aktiengesellschaft Berlin und München Wittelsbacherplatz 2 D-8000 München 2 (DE)**

(72) Erfinder : **Zschauer, Karlheinz, Dr. Pfarrer-Doktor-Rauch-Strasse 30 D-8018 Grafing (DE)**

EP 0 038 981 B1

## Beschreibung

Die vorliegende Erfindung bezieht sich auf eine Laser-Diode, wie sie aus dem Oberbegriff des Anspruches 1 hervorgeht.

Aus dem Stand der Technik (FR-A-2 437 083) sind Laser-Dioden mit einer Vielschichtstruktur aus aufeinanderliegenden epitaxial abgeschiedenen Schichten auf Galliumarsenid-Halbleiter-substrat bekannt. Diese Vielschichtstruktur enthält eine Schicht aus Galliumarsenid, in der bei Stromdurchgang die für die Erzeugung kohärenter Laser-Strahlung notwendige Umbesetzung erzeugt wird.

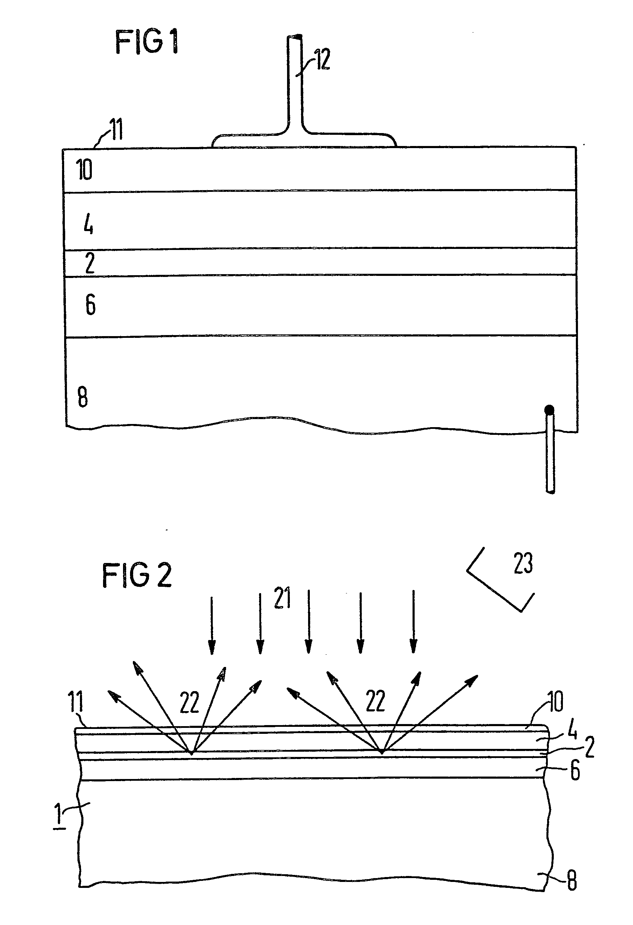

Wegen der bei einer Laser-Diode notwendigerweise hohen Stromdichten wird für den Diodenaufbau darauf geachtet, daß sowohl der Schwellenstrom für den Laser-Betrieb klein ist als auch guter Anschlußkontakt vorliegt. Beide Bedingungen führen dazu, einen wie in Fig. 1 gezeigten Schichtaufbau 1 zu wählen, bei dem die vorangehend beschriebene laseraktive Schicht 2 aus galliumarsenid mit vorzugsweise einem Aluminiumgehalt sich zwischen zwei Schichten 4, 6 aus Gallium-Aluminiumarsenid befindet. Der Aluminiumgehalt des Gallium-Aluminiumarsenid beträgt z. B. etwa 35 %, womit dieses Material gegenüber dem Galliumarsenid der Schicht 2 mit z. B. 8 % Aluminium einen für Totalreflexion ausreichenden Sprung $n_1/n_2 \neq 1$ hat, worin $n_1$ der Brechungsindex des Galliumarsenids der laseraktiven Schicht und $n_2$ der Brechungsindex des Gallium-Aluminiumarsenids der beiden erwähnten angrenzenden Schichten 4, 6 ist.

Die Dicke dieser angrenzenden Schichten 4, 6 liegt in der Größenordnung von 1 bis 5 mal, insbesondere 3 mal, der Größe der Wellenlänge der Laser-Strahlung in dem Gallium-Aluminiumarsenid- Material.

Der Aufbau der als ein Beispiel soweit beschriebenen Laser-Diode hat somit auf dem Substratkörper 8 eine erste Schicht 6 aus z. B. 35 % Aluminium enthaltendem Galliumarsenid, dann folgt die laseraktive Schicht 2 aus Gallium-Aluminiumarsenid mit z. B. 8 % Aluminium und darauf wieder eine Gallium-Aluminiumarsenid-Schicht 4 wie die erste Schicht 6.

Da sich an einer Gallium-Aluminiumarsenid-Schicht mit hohem Aluminiumgehalt wie bei der voranstehend erwähnten dritten Schicht 4 ausreichend gut leitfähige Kontakte nur mit Schwierigkeiten anbringen lassen, ist es üblich, auf dieser dritten Schicht 4 eine vierte Schicht 10 aus Galliumarsenid vorzusehen, auf deren im wesentlichen glatter äußerer Oberfläche der Kontakt 12 anzubringen ist. Das für diese Schicht 10 üblicherweise verwendete Galliumarsenid hat im übrigen einen hohen Absorptionskoeffizienten für einen Wellenlängenbereich, in dem auch die erzeugte Strahlung liegt.

Für die Herstellung von Laser-Dioden ergibt sich noch das Problem, schon während des Fertigungsprozesses feststellen zu können bzw. zu überwachen, ob die zur Kontaktierung und zum weiteren Aufbau angelieferten Substratscheiben mit den darauf befindlichen vier Epitaxialschichten 6, 2, 4 und 10 von Stück zu Stück und/oder von Charge zu Charge eine derartige Qualität, insbesondere hohes Vermögen für Strahlungserzeugung und/oder geringes Maß strahlungsloser Übergänge, haben, daß sich die nachfolgenden Maßnahmen noch lohnen.

Aufgabe der vorliegenden Erfindung ist es, für eine Vielschicht-Laser-Diode nach dem Prinzip des Oberbegriffes des Anspruches 1 einen solchen Aufbau anzugeben, bei dem eine Überprüfung der für eine Laser-Diode entscheidenden Qualitätsfaktoren noch während der Fertigung möglich ist, und zwar auf dem Wege einer zerstörungsfreien Prüfung.

Diese Aufgabe wird für eine Laser-Diode nach dem Oberbegriff des Anspruches 1 erfindungsgemäß mit den Merkmalen des Kennzeichens des Anspruches 1 gelöst. Weitere Ausgestaltungen und Weiterbildungen der Erfindung gehen aus den Unteransprüchen hervor.

Die vorliegende Erfindung beruht auf der Idee, die angelieferten Substratscheiben mit darauf befindlichen vier Schichten 6, 2, 4 and 10 durch selektive Lichtanregung mit Erzeugung von Fotolumineszenz in der laseraktiven Schicht 2 zu überprüfen und dazu die der bisherigen Praxis entgegengesetzte technische Maßnahme zu treffen, die oben bereits erwähnte vierte Schicht 10 für die Untersuchungs-Lichtstrahlung durchlässig zu machen, und zwar durch Wahl des Materials dieser vierten Schicht 10. Es ist damit die geforderte zerstörungsfreie Überprüfung durchführbar.

Fig. 2 zeigt in einem Schema die Maßnahme der vorgesehenen zerstörungsfreien Überprüfung. Mit 21 ist die in die Vielschichtstruktur 1, d. h. in die Substratscheibe mit den darauf befindlichen Epitaxialschichten, eingestrahlte Laserstrahlung bezeichnet, die in der als laseraktiv vorgesehenen Schicht 2 Fotolumineszenz erzeugt. Diese an allen von der Strahlung 21 getroffenen Stellen der Schicht 2 auftretende Spontanemission 22 wird mit Hilfe eines beispielsweise beweglichen Detektors 23 empfangen und ausgewertet. Es wird dabei nicht nur festgestellt, ob überhaupt Fotolumineszenz 22 in der Schicht 2 auftritt, sondern es läßt sich durch Abtasten prüfen, ob diese Emission 22 bezüglich Intensität und/oder Wellenlänge ausreichende Gleichmäßigkeit der Verteilung hat. Es wird damit nicht nur das unerwünschte Vorhandensein einer unzulässig hohen Anzahl von Zentren überprüft, die zu strahlungslosen Übergängen führen und/oder unerwünschte Absorption haben, sondern es läßt sich damit auch festellen, ob ein Aluminiumgehalt in dem Galliumarsenid der laseraktiven Schicht 2 ausreichend hohe Homogenität der räumlichen Verteilung hat. Es sind dies alles Faktoren, die für die Qualität der fertigen Laser-Diode entscheidend sind. Vor allem läßt sich mit diesen Maßnahmen eine Auswahl durchführen, nach der nurnoch solche Laser-Dioden fertiggestellt werden, die ganz bestimmte Wellenlänge der emittierten kohärenten Laser-Strahlung haben, wenn z. B. Interesse daran besteht, nur Laser-Dioden bestimmter klassifizierter Lichtwellenlängen herzustellen, um mit diesen Laser-Dioden in einem Lichtleiterkabel auf mehreren Lichtwellenlängen simultan trägerfrequenz aufmodulierte Signale und Signalbänder übertragen zu können.

Die Erfindung ist vorzugsweise für Substratscheiben bzw. Laser-Dioden mit einer laseraktiven Schicht von Interesse, die vergleichsweise zu dem Galliumarsenid-Substrat einen Aluminiumgehalt von beispielsweise mehr als 2, vorzugsweise 6 bis 10, Gewichtsprozent enthält. In diesem Falle ist nämlich die erzeugte Fotolumineszenz-Strahlung 22 umso viel kurzwelliger gegenüber einer aus der Strahlung 21 gleichzeitig auftretenden spontanen Emission des Galliumarsenid-Substratkörpers, daß die Strahlung 22 von spontaner Strahlung des Substratkörpers schon aufgrund verschiedener Wellenlänge ohne weiteres unterscheidbar ist.

Ein wesentliches Merkmal der Erfindung ist, die vierte Schicht 10, die an sich technisch für den Kontaktanschluß 12 vorgesehen ist, bezüglich ihres Materials, insbesondere des Aluminiumgehalts im Galliumarsenid, so auszuwählen, daß hohe Durchlässigkeit für die die Fotolumineszenz 22 erzeugende einzustrahlende Strahlung 21 besteht. Da die Fotolumineszenz-Strahlung 22 der Schicht 2 in ihrer Frequenz gleich der später erzeugten Laser-Strahlung ist, muß die Strahlung 21, nämlich damit sie die Fotolumineszenz anregen kann, etwas kurzwelliger als die Strahlung 22 sein. Für die Schicht 10 besteht damit die Bedingung, daß der Wellenlägen-Bereich ihrer Durchlässigkeit (von der langwelligen Seite her) bis über den Wellenlängen-Bereich der zu erzeugenden Laser-Strahlung hinausreicht. Es sei darauf hingewiesen, daß unter dem Wert der Wellenlänge jeweils der im Material auftretende Wellenlängen-Wert zu verstehen ist.

Diese Auswahl bzw. Begrenzung der Wellenlängen-Bereiche wird durch die Materialzusammensetzung der Schichten eingestellt. Z. B. für ein Gallium-Aluminiumarsenid mit 6 bis 8 Mol% Aluminiumgehalt für die Schicht 2 ist für die Schicht 10 ein Gallium-Aluminiumarsenid mit einem Aluminiumgehalt von etwa wenigstens 10 bis 12 Mol% nötig. Diesen Wert von 12 % Aluminium soll aber der Aluminiumgehalt der vierten Schicht 10 wiederum nicht so weit übersteigen, daß damit unnötige Schwierigkeiten bei der Anbringung des Kontakts 12 auftreten, nämlich wie dies für ein direktes Anbringen des Kontakts 12 auf der Schicht 4 der Fall wäre, die einen Aluminiumgehalt von 25 bis 40, vorzugsweise 35 % hat. Mit einem um etwa 4 Mol% höheren Aluminiumgehalt in der Schicht 10 vergleichsweise zur laseraktiven Schicht 2 hat die Schicht 10 einen um etwa 2 kT größeren Bandabstand als die Schicht 2, bezogen auf Zimmertemperatur.

Ein um etwa 2 kT größerer Bandabstand der vierten Schicht 10 gegenüber der laseraktiven Schicht 2 reicht gerade noch aus, um bei vorgegebener Arbeitstemperatur die die Fotolumineszenz 22 anregende Laserstrahlung 21 durch die Schicht 10 hindurch in die Schicht 2 ohne störende Absorption in der Schicht 10 gelangen zu lassen. Vorteilhafterweise wird jedoch ein größerer Bandabstandsunterschied von z. B. 5 kT mit einem Unterschied des Aluminiumgehalts von ca. 10 Mol% gewählt, ohne daß andererseits Kontaktschwierigkeiten auftreten. Bezüglich der Bemessungen des Aluminiumgehalts und sich daraus ergebender Bandabstandswerte sei auf das Buch « Heterostructure Lasers », Teil A.H.C. Casey u. a., Academic Press 1978 verwiesen.

Als Laser für die Strahlung 21 empfiehlt sich die Verwendung eines Farbstoff-Lasers. Laser dieser Art können mit wahlweisen Wellenlängen der erzeugten Laserstrahlung hergestellt werden. Die Einstrahlung 21 erfolgt vorzugsweise senkrecht.

Das Prinzip der Erfindung ist voranstehend für das Beispiel eines Gallium-Aluminium-Arsenid-Heterolasers beschrieben. Die Erfindung läßt sich aber auch an anderen entsprechenden Laser-Dioden realisieren, so z. B. bei einer Laser-Diode mit einer laseraktiven Schicht 2 aus Indium-Gallium-Arsenid-Phosphid, dessen Schichten 4 und 6 mit hoher Durchlässigkeit, aber hohem Sprung des Brechungsindex aus Indium-Phosphid bestehen. Für dieses Indium-Phosphid besteht ebenfalls die Schwierigkeit der Anbringung guter Kontakte, die mit einer weiteren, vierten Schicht 10 aus Indium-Gallium-Arsenid-Phosphid zu beheben ist. Die Anwendung des erfindungsgemäßen Prinzips besteht dort in der Wahl der Gallium- und Arsen-Anteile vergleichsweise zu den entsprechenden Anteilen von Gallium und Arsen in dem Indium-Gallium-Arsenid-Phosphid-Material der laseraktiven Schicht 2. Bei diesem letztgenannten speziellen Beispiel ist darauf zu achten, daß der für die Einhaltung eines Unterschieds von wenigstens 2 kT der Bandabstände notwendige unterschiedliche Gallium-Arsenid-Anteil nicht zu für die epitaxiale Abscheidung zu weit unterschiedlichen Gitter-konstanten führt. Das erstgenannte Beispiel mit Gallium-Aluminium-Arsenid hat den Vorzug, daß Probleme bezüglich der Gitterkonstanten der einzelnen epitaxialen Schichten auf dem Gallium-Arsenid-Substrat nicht auftreten.

Bei der Erfindung ist vorgesehen, daß die obere Grenzfläche der vierten Schicht 10, auf der der Kontakt 12 angebracht ist, eine möglichst ebene, spiegelnde Fläche für Strahlung der Laser-Wellenlänge der Schicht 2 ist, nämlich so wie diese Fläche sich für das Material der Schicht 10 aufgrund der üblichen epitaxialen Abscheidung ergibt. Mit dieser Maßnahme wird noch ein weiterer Vorteil einer wie erfindungsgemäß ausgebildeten Laser-Diode erzielt, nämlich daß aus der laseraktiven Schicht 2 in die Schicht 4 aufgrund ungenügender Totalreflexion austretende Streustrahlung nicht in der weiteren vierten Schicht 10 absorbiert wird, sondern an deren Oberfläche 11 bzw. an der unteren Fläche des Kontakts 12 zurückreflektiert wird und in die Schicht 2 zurückgelangen kann. Es ist damit eine. Rückgewinnung von Strahlungsenergie verbunden, die in die Bilanz der Umbesetzung in der laseraktiven Schicht 2 positiv eingeht. Dabei liegen die Verhältnisse vorteilhafterweise derart, daß solche Streustrahlung aus der laseraktiven Schicht 2 in erster Linie nur an der angrenzende Schicht 4 in größerem Maße auftritt und die Schicht 6 davon weit weniger betroffen ist. Dies beruht darauf, daß die Grenzfläche zwischen der ersten (auf dem Gallium-Arsenid-Körper 8 befindlichen) Schicht 6 und der laseraktiven Schicht 2 bei epitaxialer Abscheidung zumindest mit Flüssigphasen-Epitaxie außerordentlich glatt ist, wohingegen die Grenzfläche zwischen der laseraktiven Schicht 2 und der darauf befindlichen dritten Schicht 4 relativ rauh ist. Ein epitaxialer Schichtübergang zwischen Gallium-Arsenid mit hohem Aluminiumgehalt zu niedrigem Aluminiumgehalt ist erfahrungsgemäß wesentlich glatter als der entsprechende Übergang von niedrigem Aluminiumgehalt zu hohem Aluminiumgehalt, wie zwischen den Schichten 2 und 4.

## Ansprüche

1. Laser-Diode mit einem Vielschichtaufbau mit einer für die Laserstrahlung durchlässigen Deckschicht (4) für Totalreflexion der in der laseraktiven Schicht (2) erzeugten Strahlung und mit einem Kontakt (12), der an einer weiteren Schicht (10), die sich zwischen Deckschicht und diesem Kontakt befindet, angebracht ist, gekennzeichnet dadurch, daß das Halbleitermaterial dieser weiteren Schicht (10) einen vergleichsweise zum Material der laseraktiven Schicht (2) um wenigstens 2 kT größeren Bandabstand hat, und daß die äußere Oberfläche (11) dieser weiteren Schicht (10) für in der laseraktiven Schicht (2) erzeugte Strahlung spiegelnd glatt ist.

2. Laser-Diode nach Anspruch 1, dadurch gekennzeichnet, daß der Bandabstand des Materials der weiteren Schicht (10) wenigstens 5 kT größer als derjenige des Materials der laseraktiven Schicht (2) ist.

3. Laser-Diode nach Anspruch 1 oder 2, dadurch gekennzeichnet, daß das Material der laseraktiven Schicht (2) $GaAl_xAs$ und daß das Material der weiteren Schicht (10) $GaAl_{x'}As$ ist, worin $x'$ ein um 0,04 größerer Mol-Gehalt an Aluminium ist als der Mol-Gehalt x im Material der laseraktiven Schicht (2) beträgt.

## Claims

1. A laser diode having a multilayer structure with a covering layer (4), which is permeable to the laser radiation, for total internal reflection of the radiation produced in the laser-active layer (2), and a contact (12) which is applied to a further layer (10) located between the covering layer and this contact, characterised in that the semiconductor material of the further layer (10) has an energy gap which is greater by at least 2 kT as compared with the material of the laser-active layer (2) ; and that the outer surface (11) of the further layer (10) is mirror-smooth for radiation produced in the laser-active layer (2).

2. A laser diode according to Claim 1, characterised in that the energy gap of the material of the further layer (10) is greater by at least 5 kT than that of the material of the laser-active layer (2).

3. A laser diode according to Claim 1 or Claim 2, characterised in that the material of the laser-active layer (2) is $GaAl_xAs$ and that the material of the further layer (10) is $GaAl_{x'}As$, where $x'$ represents a mole content of aluminium which is greater by 0,04 than the mole content x of aluminium in the material of the laser-active layer (2).

## Revendications

1. Diode laser à constitution multi-couche, avec une couche de couverture (4), transparente pour le rayonnement laser, pour la réflexion totale du rayonnement produit dans la couche (2) à activité laser, et avec un contact (12) qui se situe au niveau d'une seconde couche (10) qui se trouve entre la couche de couverture et ce contact, caractérisée par le fait que le matériau semiconducteur de cette seconde couche (10) possède un intervalle d'énergie qui est comparativement au matériau de la couche (2) à activité laser, d'au moins 2 kT plus grand, et que la couche extérieure (11) de cette seconde couche (10) a le poli d'un miroir pour le rayonnement produit dans la couche (2) à activité laser.

2. Diode laser selon la revendication 1, caractérisée par le fait que l'intervalle d'énergie du matériau de la seconde couche (10) est au moins 5 kT fois plus grand que celui du matériau de la couche (2) à activité laser.

3. Diode laser selon la revendication 1 ou 2, caractérisée par le fait que le matériau de la couche (2) à activité laser est le $GaAl_xAs$ et le matériau de la seconde couche (10) est le $GaAl_{x'}As$, où $x'$ est une teneur molaire en aluminium qui est de 0,04 fois plus grande que la teneur molaire x de la couche (2) à activité laser.

## FIG 1

## FIG 2